# EUROPEAN PATENT APPLICATION

(11) **EP 4 661 301 A1**
(43) Date of publication of application: **10.12.2025**
(21) Application number: 24789087.4
(22) Date of filing: 12.04.2024
(51) Int. Cl.: H04B 1/401, H03F 3/195, H04B 1/04, H04W 88/06

(54) **ELECTRONIC DEVICE COMPRISING CONVERGED POWER AMPLIFIER AND METHOD OF OPERATING SAME**

(30) Priority: 12.04.2023 KR 20230048408
(71) Applicant: Samsung Electronics Co., Ltd., Suwon-si, Gyeonggi-do 16677 (KR)
(72) Inventor: KANG, Hyunsang, Suwon-si Gyeonggi-do 16677 (KR); MOON, Yohan, Suwon-si Gyeonggi-do 16677 (KR); NA, Hyoseok, Suwon-si Gyeonggi-do 16677 (KR); VAN, Juho, Suwon-si Gyeonggi-do 16677 (KR); AN, Yongjun, Suwon-si Gyeonggi-do 16677 (KR)
(74) Representative: Gulde & Partner
(86) International application number: PCT/KR2024/004962
(87) International publication number: WO 2024/215146

(57) **Abstract**

According to one embodiment, an electronic device comprises: a memory that stores instructions; a first power amplifier (PA) selectively connected to at least one of a plurality of modulators via a first switch; a first modulator of the plurality of modulators that includes a second switch connected between the first switch and a first capacitor, and a third switch connected to an output end of a first buck converter, and is configured to operate in an envelope tracking (ET) mode or an average power tracking (APT) mode; a second modulator of the plurality of modulators that includes a fourth switch connected between the first switch and a second capacitor, and a fifth switch connected to an output end of a second buck converter, and is configured to operate in an ET mode or an APT mode; and at least one processor that is operatively coupled to the first PA, the first modulator, and the second modulator, and comprises a processing circuit, wherein the instructions, when executed by the at least one processor, cause the electronic device to control the first modulator to operate in the APT mode on the basis of identifying a first event associated with network communication, control the first switch so as to couple the first PA to the first modulator and the second modulator, control the second switch, the third switch, and the fourth switch to be turned on, and control the fifth switch to be turned off on the basis of the first modulator operating in the APT mode.

## Description

### [Technical Field]

Various embodiments of the disclosure relate to an electronic device including a converged power amplifier and a method for operating the same.

### [Background Art]

Electronic devices supporting non-terrestrial network communication (e.g., satellite communication) are being actively introduced. As an example, an electronic device may communicate with a satellite of a satellite communication company using the frequency and communication scheme of the company. As an example, an electronic device may communicate with a satellite using a long-term evolution (LTE) standard cellular frequency based on the LTE standard (or 5G standard). As an example, an electronic device may communicate with a satellite based on the 5G non-terrestrial networks (NTN) standard.

For example, when an electronic device communicates with a non-terrestrial network based on the LTE standard, some of the frequencies defined in the LTE standard may be allocated for non-terrestrial communication. An electronic device may perform satellite communication using a protocol stack used in terrestrial communication and may require no further protocol stack for non-terrestrial communication.

To transmit a signal from an electronic device to a communication network (e.g., a base station), data generated from a processor or a communication processor in the electronic device may be signal-processed through a radio frequency integrated circuit (RFIC) and radio frequency front-end (RFFE) circuit and then transmitted to the outside of the electronic device through at least one antenna. The electronic device may include at least one antenna to transmit signals of various frequency bands. At least one antenna may be configured to support signals of a plurality of frequency bands based on a multiplexer. The electronic device may determine the output of the power amplifier inside the RFFE circuit based on the maximum transmit power allowed for stable communication at the cell edge.

### [Disclosure of Invention]

### [Solution to Problems]

According to an example embodiment, an electronic device may comprise: memory storing instructions, a first power amplifier (PA) selectively connected to at least one of a plurality of modulators through a first switch, a first modulator including a second switch connected between the first switch and a first capacitor and a third switch connected to an output end of a first buck converter, the first modulator being among the plurality of modulators configured to selectively operate in an envelope tracking (ET) mode or an average power tracking (APT) mode, a second modulator including a fourth switch connected between the first switch and a second capacitor and a fifth switch connected to an output end of a second buck converter, the second modulator being among the plurality of modulators configured to selectively operate in the ET mode or the APT mode, and at least one processorcomprising processing circuitry, operatively connected to the first PA, the first modulator, and the second modulator. The instructions, when executed by at least one processor, may cause the electronic device to: control the first modulator to operate in the APT mode based on identifying a first event associated with network communication and control the first switch to connect the first PA to the first modulator and the second modulator. The instructions, when executed by at least one processor, may cause the electronic device to control the second switch, the third switch, and the fourth switch to turn on. The instructions, when executed by at least one processor, may cause the electronic device to control the fifth switch to turn off while the first modulator operates in the APT mode.

According to an example embodiment, in a computer-readable storage medium storing at least one computer-readable instruction, the at least one instruction may, when executed by at least one processor of the electronic device, cause the electronic device to perform at least one operation. The at least one operation may comprise controlling a first modulator of the electronic device configured to selectively operate in an envelope tracking (ET) mode or an average power tracking (APT) mode to operate in the APT mode based on identifying a first event associated with network communication, controlling a first switch of the electronic device to connect a first PA of the electronic device to the first modulator and a second modulator. The at least one operation may comprise controlling a second switch and a third switch of the first modulator and a fourth switch of a second modulator of the electronic device to turn on. The at least one operation may comprise controlling a fifth switch of the second modulator to turn off while the first modulator operates in the APT mode.

According to an example embodiment, a method for operating an electronic device may comprise: controlling a first modulator of the electronic device configured to selectively operate in an envelope tracking (ET) mode or an average power tracking (APT) mode to operate in the APT mode based on identifying a first event associated with network communication, controlling a first switch of the electronic device to connect a first PA of the electronic device to the first modulator and a second modulator The method may comprise controlling a second switch and a third switch of the first modulator and a fourth switch of a second modulator of the electronic device to turn on. The method may comprise controlling a fifth switch of the second modulator to turn off while the first modulator operates in the APT mode.

### [Brief Description of Drawings]

FIG. 1 is a block diagram illustrating an electronic device in a network environment according to an embodiment;
FIG. 2A is a block diagram illustrating an electronic device for supporting legacy network communication and 5G network communication according to an embodiment;
FIG. 2B is a block diagram illustrating an electronic device for supporting legacy network communication and 5G network communication according to an embodiment;
FIG. 3 is a view illustrating access to an electronic device according to an embodiment;
FIG. 4 is a block diagram illustrating an electronic device for supporting a plurality of network communications according to an embodiment;
FIG. 5A is a view illustrating an operation of a modulator according to an embodiment;
FIG. 5B is a view illustrating an operation of a modulator according to an embodiment;
FIG. 6 is a view illustrating an operation of a modulator according to an embodiment;
FIG. 7A is a view illustrating operations of modulators according to an embodiment;
FIG. 7B is a view illustrating operations of modulators according to an embodiment;
FIG. 7C is a view illustrating operations of modulators according to an embodiment;
FIG. 8A is a flowchart illustrating an operation method of an electronic device according to an embodiment;
FIG. 8B is a flowchart illustrating an operation method of an electronic device according to an embodiment;
FIG. 8C is a flowchart illustrating an operation method of an electronic device according to an embodiment; and
FIGS. 9A and 9B are block diagrams illustrating an electronic device for supporting non-terrestrial network communication according to an embodiment.

### [Mode for the Invention]

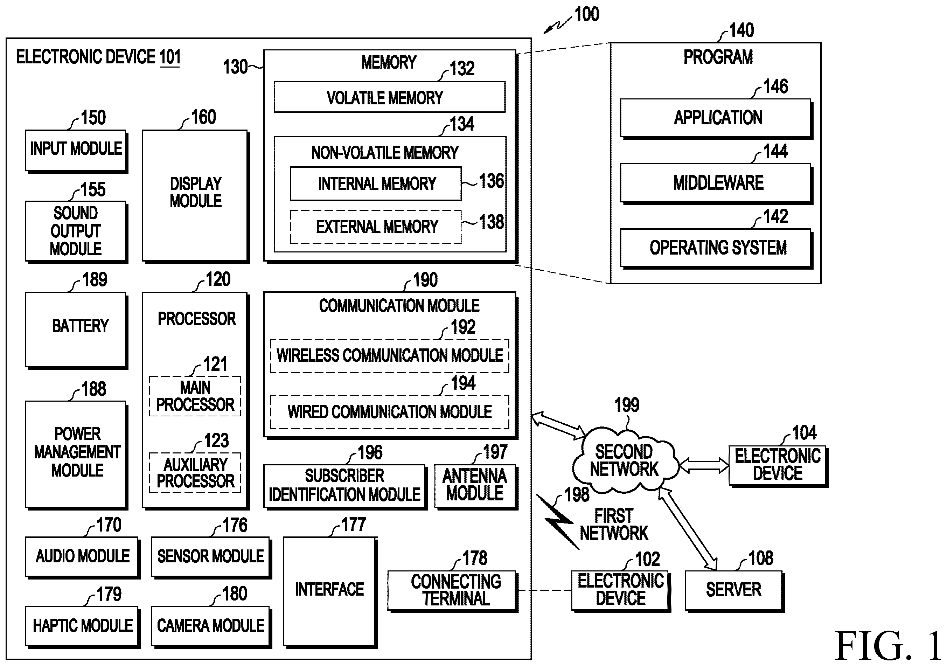

FIG. 1 is a block diagram illustrating an example electronic device 101 in a network environment 100 according to an embodiment. Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal According to an embodiment, the display module 160 may include a first display module 351 corresponding to the user's left eye and/or a second display module 353 corresponding to the user's right eye., a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductive body or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

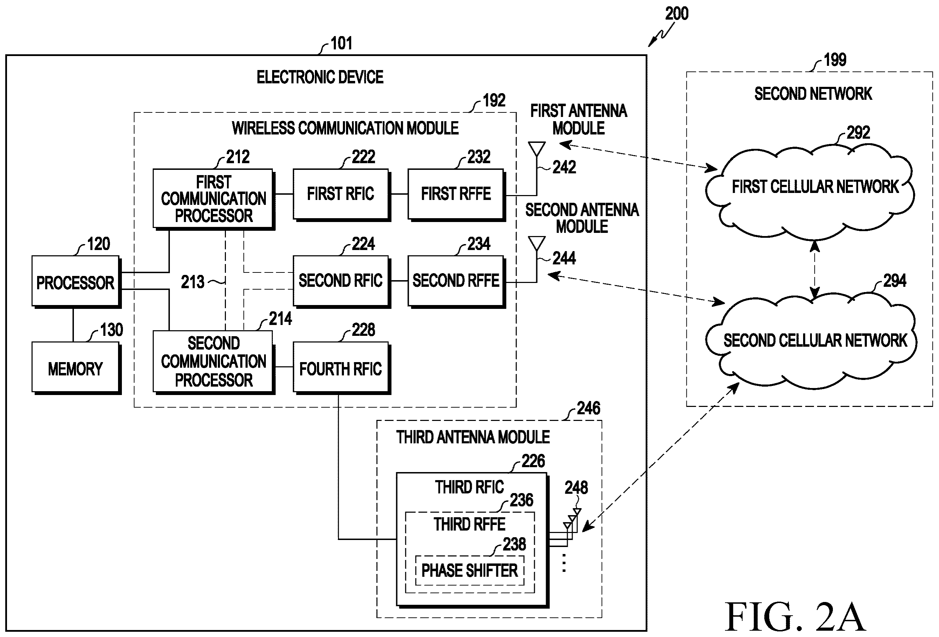

FIG. 2A is a block diagram 200 illustrating an electronic device 101 for supporting legacy network communication and 5G network communication according to an embodiment. Referring to FIG. 2A, the electronic device 101 may include a first communication processor (e.g., including processing circuitry) 212, a second communication processor (e.g., including processing circuitry) 214, a first radio frequency integrated circuit (RFIC) 222, a second RFIC 224, a third RFIC 226, a fourth RFIC 228, a first radio frequency front end (RFFE) 232, a second RFFE 234, a first antenna module (e.g., including at least one antenna) 242, a second antenna module (e.g., including at least one antenna) 244, a third antenna module (e.g., including at least one antenna) 246, and antennas 248. The electronic device 101 may further include a processor (e.g., including processing circuitry) 120 and a memory 130. The second network 199 may include a first cellular network 292 and a second cellular network 294. According to an embodiment, the electronic device 101 may further include at least one component among the components of FIG. 1, and the second network 199 may further include at least one other network. According to an embodiment, the first communication processor 212, the second communication processor 214, the first RFIC 222, the second RFIC 224, the fourth RFIC 228, the first RFFE 232, and the second RFFE 234 may form at least part of the wireless communication module 192. According to an embodiment, the fourth RFIC 228 may be omitted or be included as part of the third RFIC 226.

The first communication processor 212 may establish a communication channel of a band that is to be used for wireless communication with the first cellular network 292 or may support legacy network communication via the established communication channel. According to an embodiment, the first cellular network may be a legacy network that includes second generation (2G), third generation (3G), fourth generation (4G), or long-term evolution (LTE) networks. The second communication processor 214 may establish a communication channel corresponding to a designated band (e.g., from about 6GHz to about 60GHz) among bands that are to be used for wireless communication with the second cellular network 294 or may support fifth generation (5G) network communication via the established communication channel. According to an embodiment, the second cellular network 294 may be a 5G network defined by the 3rd generation partnership project (3GPP). Additionally, according to an embodiment, the first communication processor 212 or the second communication processor 214 may establish a communication channel corresponding to another designated band (e.g., about 6GHz or less) among the bands that are to be used for wireless communication with the second cellular network 294 or may support fifth generation (5G) network communication via the established communication channel.

The first communication processor 212 may perform data transmission/reception with the second communication processor 214. For example, data classified as transmitted via the second cellular network 294 may be changed to be transmitted via the first cellular network 292. In this case, the first communication processor 212 may receive transmission data from the second communication processor 214. For example, the first communication processor 212 may transmit/receive data to/from the second communication processor 214 via an inter-processor interface 213. The inter-processor interface 213 may be implemented as, e.g., universal asynchronous receiver/transmitter (UART) (e.g., high speed-UART (HS-UART)) or peripheral component interconnect bus express (PCIe) interface, but is not limited to a specific kind. The first communication processor 212 and the second communication processor 214 may exchange packet data information and control information using, e.g., a shared memory. The first communication processor 212 may transmit/receive various types of information, such as sensing information, information about output strength, and resource block (RB) allocation information, to/from the second communication processor 214.

According to implementation, the first communication processor 212 may not be directly connected with the second communication processor 214. In this case, the first communication processor 212 may transmit/receive data to/from the second communication processor 214 via a processor 120 (e.g., an application processor). For example, the first communication processor 212 and the second communication processor 214 may transmit/receive data to/from the processor 120 (e.g., an application processor) via an HS-UART interface or PCIe interface, but the kind of the interface is not limited thereto. The first communication processor 212 and the second communication processor 214 may exchange control information and packet data information with the processor 120 (e.g., an application processor) using a shared memory.

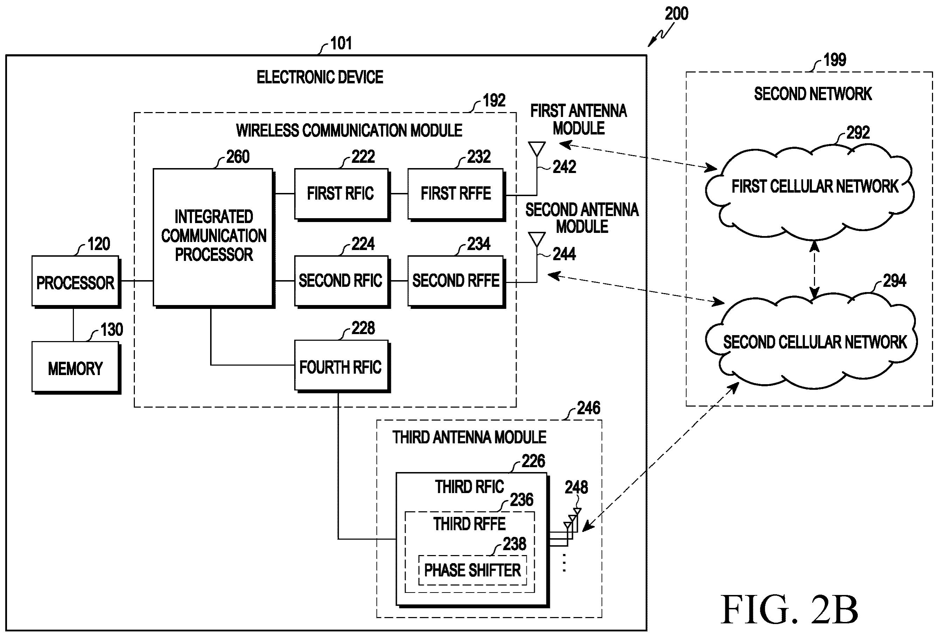

According to an embodiment, the first communication processor 212 and the second communication processor 214 may be implemented in a single chip or a single package. According to an embodiment, the first CP 212 or the second CP 214, along with the processor 120, an assistance processor 123, or communication module 190, may be formed in a single chip or single package. For example, as shown in FIG. 2B, an integrated communication processor 260 may support all of the functions for communication with the first cellular network 292 and the second cellular network 294.

As described above, at least one of the processor 120, the first communication processor 212, the second communication processor 214, or the integrated communication processor 260 may be implemented as a single chip or a single package. In this case, the single chip or single package may include a memory (or storage means) storing instructions that cause at least some of operations performed according to an embodiment and a processing circuit (or operation circuit, but the term is not limited) for executing instructions.

Upon transmission, the first RFIC 222 may convert a baseband signal generated by the first communication processor 212 into a radio frequency (RF) signal with a frequency ranging from about 700MHz to about 3GHz which is used by the first cellular network 292 (e.g., a legacy network). Upon receipt, the RF signal may be obtained from the first network 292 (e.g., a legacy network) through an antenna (e.g., the first antenna module 242) and be pre-processed via an RFFE (e.g., the first RFFE 232). The first RFIC 222 may convert the pre-processed RF signal into a baseband signal that may be processed by the first communication processor 212.

Upon transmission, the second RFIC 224 may convert the baseband signal generated by the first communication processor 212 or the second communication processor 214 into a Sub6-band (e.g., about 6GHz or less) RF signal (hereinafter, "5G Sub6 RF signal") that is used by the second cellular network 294 (e.g., a 5G network). Upon receipt, the 5G Sub6 RF signal may be obtained from the second cellular network 294 (e.g., a 5G network) through an antenna (e.g., the second antenna module 244) and be pre-processed via an RFFE (e.g., the second RFFE 234). The second RFIC 224 may convert the pre-processed 5G Sub6 RF signal into a baseband signal that may be processed by a corresponding processor of the first communication processor 212 and the second communication processor 214.

The third RFIC 226 may convert the baseband signal generated by the second CP 214 into a 5G Above6 band (e.g., from about 6GHz to about 60GHz) RF signal (hereinafter, "5G Above6 RF signal") that is to be used by the second cellular network 294 (e.g., a 5G network). Upon receipt, the 5G Above6 RF signal may be obtained from the second cellular network 294 (e.g., a 5G network) through an antenna (e.g., the antenna 248) and be pre-processed via the third RFFE 236. The third RFIC 226 may convert the pre-processed 5G Above6 RF signal into a baseband signal that may be processed by the second communication processor 214. According to an embodiment, the third RFFE 236 may be formed as part of the third RFIC 226.

According to an embodiment, the electronic device 101 may include the fourth RFIC 228 separately from, or as at least part of, the third RFIC 226. In this case, the fourth RFIC 228 may convert the baseband signal generated by the second communication processor 214 into an intermediate frequency band (e.g., from about 9GHz to about 11GHz) RF signal (hereinafter, "IF signal") and transfer the IF signal to the third RFIC 226. The third RFIC 226 may convert the IF signal into a 5G Above6 RF signal. Upon receipt, the 5G Above6 RF signal may be received from the second cellular network 294 (e.g., a 5G network) through an antenna (e.g., the antenna 248) and be converted into an IF signal by the third RFIC 226. The fourth RFIC 228 may convert the IF signal into a baseband signal that may be processed by the second communication processor 214.

According to an embodiment, the first RFIC 222 and the second RFIC 224 may be implemented as at least part of a single chip or single package. According to an embodiment, when the first RFIC 222 and the second RFIC 224 in FIG. 2A or 2B are implemented as a single chip or a single package, they may be implemented as an integrated RFIC. In this case, the integrated RFIC is connected to the first RFFE 232 and the second RFFE 234 to convert a baseband signal into a signal of a band supported by the first RFFE 232 and/or the second RFFE 234, and may transmit the converted signal to one of the first RFFE 232 and the second RFFE 234. According to an embodiment, the first RFFE 232 and the second RFFE 234 may be implemented as at least part of a single chip or single package. According to an embodiment, at least one of the first antenna module 242 or the second antenna module 244 may be omitted or be combined with another antenna module to process multi-band RF signals.

According to an embodiment, the third RFIC 226 and the antenna 248 may be disposed on the same substrate to form the third antenna module 246. For example, the wireless communication module 192 or the processor 120 may be disposed on a first substrate (e.g., a main painted circuit board (PCB)). In this case, the third RFIC 226 and the antenna 248, respectively, may be disposed on one area (e.g., the bottom) and another (e.g., the top) of a second substrate (e.g., a sub PCB) which is provided separately from the first substrate, forming the third antenna module 246. Placing the third RFIC 226 and the antenna 248 on the same substrate may shorten the length of the transmission line therebetween. This may reduce a loss (e.g., attenuation) of high-frequency band (e.g., from about 6GHz to about 60GHz) signal used for 5G network communication due to the transmission line. Thus, the electronic device 101 may enhance the communication quality with the second network 294 (e.g., a 5G network).

According to an embodiment, the antenna 248 may be formed as an antenna array which includes a plurality of antenna elements available for beamforming. In this case, the third RFIC 226 may include a plurality of phase shifters 238 corresponding to the plurality of antenna elements, as part of the third RFFE 236. Upon transmission, the plurality of phase shifters 238 may change the phase of the 5G Above6 RF signal which is to be transmitted to the outside (e.g., a 5G network base station) of the electronic device 101 via their respective corresponding antenna elements. Upon receipt, the plurality of phase shifters 238 may change the phase of the 5G Above6 RF signal received from the outside to the same or substantially the same phase via their respective corresponding antenna elements. This enables transmission or reception via beamforming between the electronic device 101 and the outside.

The second cellular network 294 (e.g., a 5G network) may be operated independently (e.g., as standalone (SA)) from, or in connection (e.g., as non-standalone (NSA)) with the first cellular network 292 (e.g., a legacy network). For example, the 5G network may have the access network (e.g., 5G radio access network (RAN) or next generation RAN (NG RAN)) but may not have the core network (e.g., next generation core (NGC)). In this case, the electronic device 101, after accessing a 5G network access network, may access an external network (e.g., the Internet) under the control of the core network (e.g., the evolved packet core (EPC)) of the legacy network. Protocol information (e.g., LTE protocol information) for communication with the legacy network or protocol information (e.g., New Radio (NR) protocol information) for communication with the 5G network may be stored in the memory 230 and be accessed by other components (e.g., the processor 120, the first communication processor 212, or the second communication processor 214).

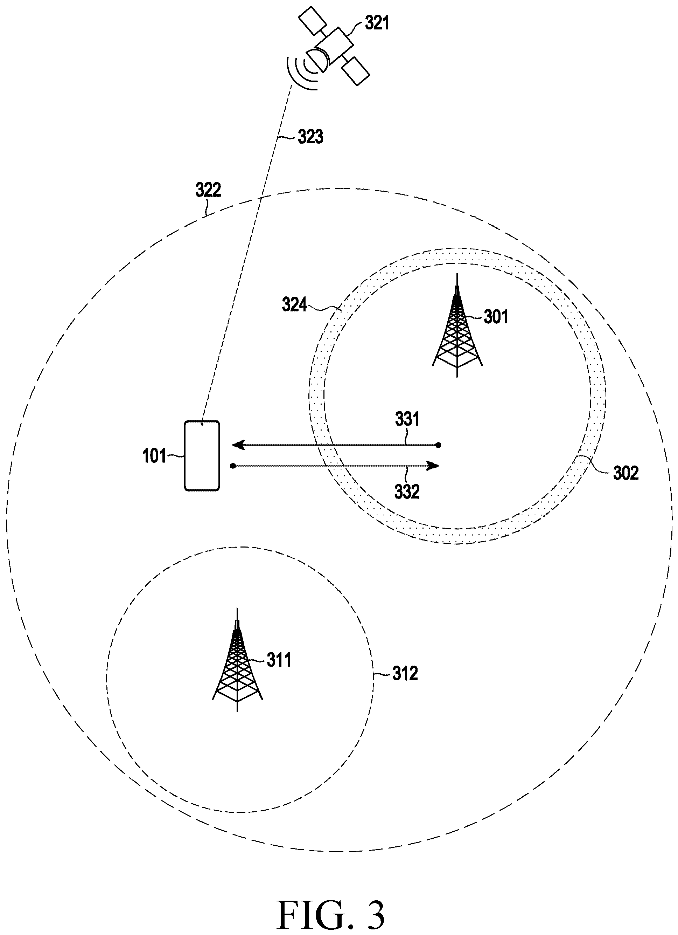

FIG. 3 is a view illustrating access to an electronic device according to an embodiment.

According to an embodiment, the electronic device 101 may be positioned within the coverage 322 of the satellite 321. It will be appreciated by one of ordinary skill in the art that the satellite 321 may be replaced with another type of electronic device supporting non-terrestrial communication in various embodiments of the disclosure. The electronic device 101 may access (323) the satellite 321 within the coverage 322 of the satellite 321. For example, the electronic device 101 may perform a cell scan within the coverage 322 of the satellite 321. The electronic device 101 may identify the satellite 321 (which may be referred to as a cell corresponding to the satellite 321) as a result of performing the cell scan. When the satellite 321 meets a cell selection condition, the electronic device 101 may camp on the satellite 321. The electronic device 101 may camp on the satellite 321 and may perform at least one operation for establishing a connection (e.g., radio resource control (RRC) connection) with the satellite 321. The electronic device 101 may perform at least one operation for attachment (or registration) to a core network (e.g., MME or AMF) corresponding to the satellite 321, based on the established connection. The access 323 to the satellite 321 may include, e.g., camping on, establishing a connection, and/or attaching, but is not limited thereto. The coverage 322 of satellite communication may be relatively wider (e.g., 50 times wider) than the coverage 302 and 312 by the terrestrial base stations 301 and 311. The coverage 322 based on satellite communication may cover, e.g., an area not covered by the coverage 302 and 312 by terrestrial communication, and accordingly, the user may perform communication using the electronic device 101 even in an area where terrestrial communication is not supported.

For example, satellite communication based on the satellite 321 may support limited frequency resources and/or limited services. Satellite communication may provide, e.g., a limited service such as an emergency service (e.g., an emergency call) and/or a short message service (SMS), and may not support a service (e.g., video streaming, but not limited thereto) for transmitting and receiving other general data. In an embodiment, satellite communication may support a limited bandwidth (e.g., 1.4 MHz) compared to terrestrial communication. For example, in satellite communication, even when a voice call and/or a data service is supported, the entire cell capacity may be relatively low as 2 to 4 Mbps. On the other hand, the terrestrial communication may support a bandwidth of up to, e.g., 100 MHz when carrier aggregation (CA) is activated, and the cell capacity may also exceed 1 Gbps. In an embodiment, the electronic device 101 may move (331) out of the coverage 302 from a position within the coverage 302 by terrestrial communication, or may move (332) out of the coverage 302 into the coverage 302. In an embodiment, the electronic device 101 may be positioned in the boundary area 324 of the coverage 302 by terrestrial communication. Even after the electronic device 101 accesses the satellite 321 (323), if the terrestrial base stations 301 and 311 are detected based on the position of the electronic device 101, the electronic device 101 may access the terrestrial base stations 301 and 311.

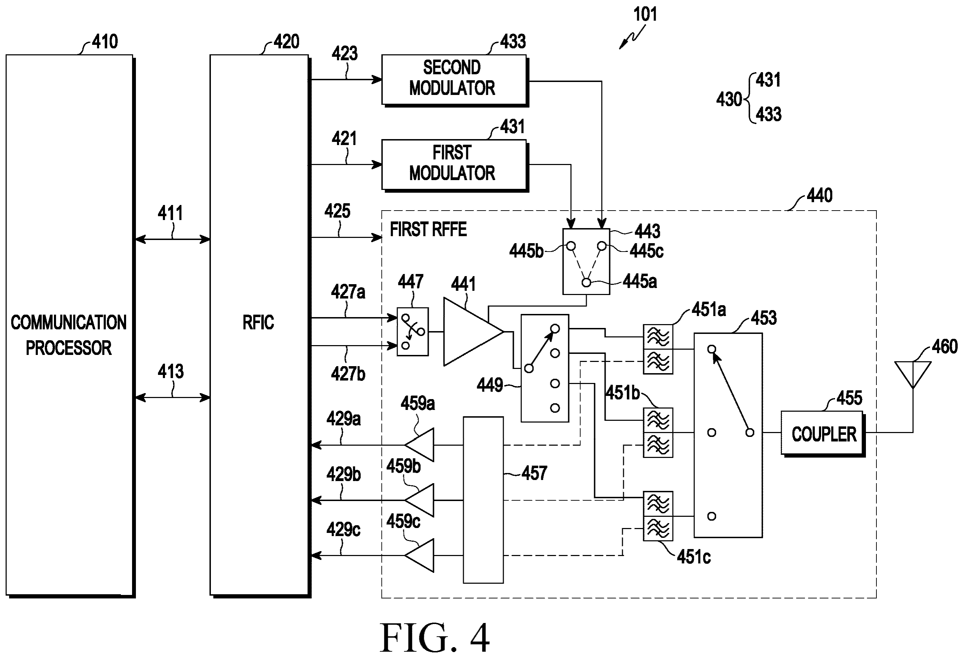

FIG. 4 is a block diagram illustrating an electronic device for supporting a plurality of network communications according to an embodiment.

In an embodiment, referring to FIG. 4, the electronic device 101 may include at least one communication processor (e.g., including processing circuitry) 410, at least one RFIC 420, at least one modulator 430, a first RFFE 440, and/or an antenna module (e.g., including at least one antenna) 460.

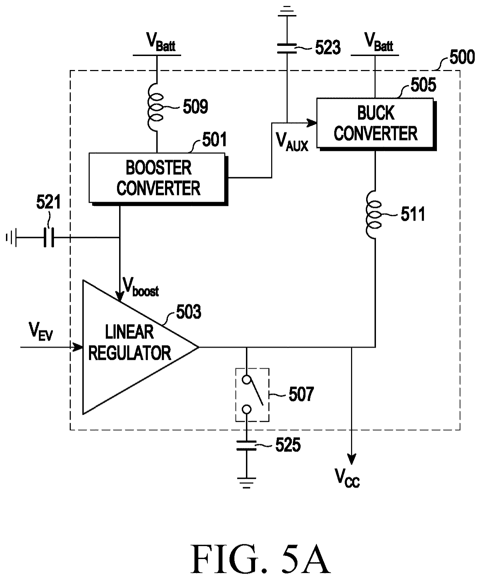

In an embodiment, the at least one communication processor 410 (e.g., the processor 120, the first communication processor 212, the second communication processor 214, and/or the integrated communication processor 260) may change the operation mode of the at least one modulator 430 (e.g., the first modulator 431 or the second modulator 433). The at least one communication processor 410 may control the state of the SPnT switch 443 included in the at least one RFFE (e.g., the first RFFE 440). For example, the communication processor 410 may control the at least one modulator 430 and/or the SPnT switch 443 based on transmitting a control signal to the at least one RFIC 420 through a control line 411. In an embodiment, the communication processor 410 may transmit a signal associated with transmission data to the RFIC 420 through at least one signal line 413. An operation in which the communication processor 410 controls the at least one RFIC 420 to change the magnitude of the voltage supplied to at least one converged PA (e.g., the first PA 441) is described below with reference to FIGS. 5A to 11.

In an embodiment, the at least one RFIC 420 (e.g., the first RFIC 222, the second RFIC 224, the third RFIC 226, and/or the fourth RFIC 228) may output an RF signal in a frequency band corresponding to network communication through at least one transmission line (e.g., the first transmission line 427a and/or the second transmission line 427b) upon transmission. Upon receipt, the at least one RFIC 420 may process an RF signal transferred by the first RFFE 440 through at least one reception line (e.g., the first reception line 429a, the second reception line 429b, and/or the third reception line 429c). The signal converted to the baseband by the at least one RFIC 420 may be transferred to the communication processor 410 through at least one signal line 413. In an embodiment, the at least one RFIC 420 may change the operation mode of the at least one modulator 430, based on receiving a control signal from the communication processor 410 through the control line 411. For example, the at least one RFIC 420 may control the first modulator 431 to operate in an ET mode or an APT mode through the control line 421, based on the MIPI. The at least one RFIC 420 may control the second modulator 433 to operate in an envelope tracking (ET) mode or an average power tracking (APT) mode through the control line 423, based on the MIPI. In an embodiment, the at least one RFIC 420 may control the state of at least one switch (e.g., the SPnT switch 443, the SPDT switch 447, the transmission switch 449, the antenna switching module 453, and/or the reception switch 457) included in the first RFFE 440, based on transmitting a control signal to the first RFFE 440 through the control line 425.

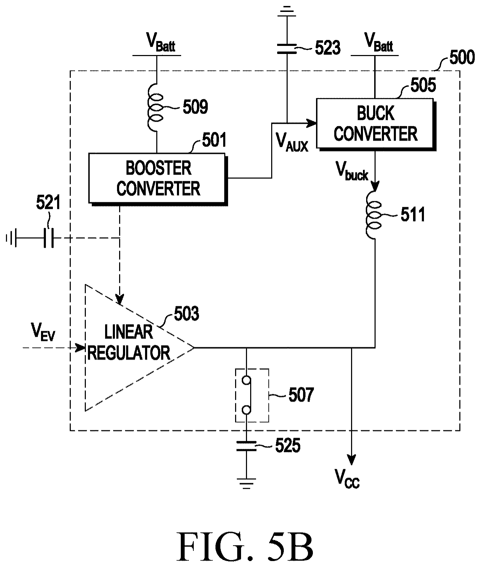

In an embodiment, the at least one modulator 430 (e.g., the first modulator 431 or the second modulator 433) may be electrically connected to at least one RFFE and may supply power to a power amplifier (hereinafter, "PA") included in the at least one RFFE. In an embodiment, the magnitude of the voltage output by the at least one modulator 430 may be changed according to the operation mode of the modulator. In an embodiment, the first modulator 431 (e.g., first power supply) and the second modulator 433 (e.g., second power supply) may be modulators configured to selectively operate in the ET mode and the APT mode. A modulator supporting both the ET mode and the APT mode may be referred to as an "ET modulator", but is not limited thereto. The operation mode of the modulator is described in greater detail below with reference to FIGS. 5A and 5B. In an embodiment, each of the first modulator 431 (or first PMIC) and the second modulator 433 (or second PMIC) may be implemented as a chip.

In an embodiment, the first RFFE 440 may process an RF signal corresponding to network communication. The first RFFE 440 may include a first PA 441, an SPnT switch 443, an SPDT switch 447, a transmission switch 449, at least one duplexer (e.g., the first duplexer 451a, the second duplexer 451b, and/or the third duplexer 451c), an antenna switching module 453, a coupler 455, a reception switch 457, and/or at least one low-noise amplifier (LNA) (e.g., the first LNA 459a, the second LNA 459b, and/or the third LNA 459c). In an embodiment, the first PA 441 may be selectively connected to at least one of the first modulator 431 or the second modulator 433 through the SPnT switch 443. In an embodiment, the SPnT switch 443 may be turned on or off based on a control signal of the communication processor 410 and/or the at least one RFIC 420. The SPnT switch 443 may electrically connect the input port 445a to at least one output port (e.g., the first output port 445b and/or the second output port 445c) in the turned-on state. The SPnT switch 443 may operate in a "multi-on" state in which the input port 445a is connected to the plurality of output ports 445b and 445c. The SPnT switch 443 may operate in a "single-on" state in which the input port 445a is connected to any one output port. The first PA 441 may be turned on by power supplied through the first modulator 431 and/or the second modulator 433. The first PA 441 may be a converged PA configured to amplify RF signals corresponding to a plurality of communication networks. For example, the converged PA may amplify an RF signal corresponding to a 2G communication network, a 3G communication network, an LTE communication network, a 5G communication network, and/or a non-terrestrial network communication network, and the plurality of communication networks are not limited to the above-described example. The converged PA may be referred to as an "integrated design PA", and the term is not limited thereto. In an embodiment, the SPDT switch 447 may electrically connect the first PA 441 to at least one RFIC 420, based on switching. For example, the SPDT switch 447 may perform a switching operation so that an RF signal is input to the first PA 441 through the first transmission line 427a or the second transmission line 427b, based on a control signal of the communication processor 410 and/or the at least one RFIC 420. For example, the first PA 441 may amplify an RF signal corresponding to the first network communication output from the at least one RFIC 420 through the first transmission line 427a. The first PA 441 may amplify an RF signal corresponding to the second network communication output from the at least one RFIC 420 through the second transmission line 427b. Specific examples of the first network communication and/or the second network communication are described below. In an embodiment, upon transmission, the transmission switch 449 and/or the antenna switch module 453 may electrically connect the first PA 441 with any one of at least one duplexer 451a, 451b, and 451c and the antenna module 460 based on switching. Each duplexer may include a filter corresponding to a set network communication and/or frequency band. The RF signal amplified by the first PA 441 may be transmitted to the antenna module 460 through a duplexer and a coupler corresponding to the network communication and/or the frequency band. The coupler 455 may measure RF power from an RF source to a load and power reflected from the load to the source. The antenna module 460 may radiate a transmission signal corresponding to network communication to the outside. In an embodiment, upon reception, the reception switch 457 and/or the antenna switch module 453 may electrically connect at least one LNA 459a, 459b, and 459c to a corresponding duplexer among at least one duplexer 451a, 451b, and 451c. The signal received by the antenna module 460 may pass through the coupler 455 and the duplexer and may be amplified by the LNA corresponding to the network communication and/or the frequency band. The signal amplified by the LNA may be transmitted to the RFIC 420 through the reception line. In an embodiment, the SPnT switch 443 and the first PA 441 may be included in the first RFFE 440 and may be implemented as a single chip. In case that the SPnT switch 443 and the first PA 441 are implemented as a single chip, the efficiency of internal mounting space may be improved in terms of RF hardware design.

In an embodiment, the antenna module (e.g., the antenna module 197, the first antenna module 242, the second antenna module 244, the third antenna module 246, and/or the antennas 248) may radiate an RF signal or receive a signal from the outside. Although FIG. 4 illustrates only one antenna module for convenience of description, those skilled in the art will understand that the electronic device 101 may include a plurality of antenna modules. In an embodiment, upon transmission, the antenna module 460 may transmit a signal corresponding to network communication, based on a signal amplified by the first PA 441. Upon reception, the antenna module 460 may receive a signal corresponding to network communication. In an embodiment, the electronic device 101 may further include the components illustrated in FIG. 1, 2A and/or 2B, in addition to the components illustrated in FIG. 4.

FIG. 5A is a view illustrating an operation of a modulator according to an embodiment.

FIG. 5B is a view illustrating an operation of a modulator according to an embodiment.

In an embodiment, the modulator 500 (e.g., the first modulator 431 and/or the second modulator 433) may include a boost converter 501, a linear regulator 503, a buck converter 505, and/or an APT switch 507. In an embodiment, the modulator 500 may be a modulator supporting an ET mode and an APT mode. The modulator 500 may operate in the ET mode or the APT mode based on controlling the state of the APT switch 507. In an embodiment, one end of the APT switch 507 may be connected to a capacitor 525, and the other end may be connected to a PA (e.g., the first PA 441). The modulator 500 may change the operation state based on a control signal of a communication processor (e.g., the communication processor 410 and/or the RFIC 420). In an embodiment, the modulator 500 may be electrically connected to a battery (e.g., the battery 189) and may output a voltage V_{cc} converted based on the output voltage V_{Batt} of the battery.

In an embodiment, referring to FIG. 5A, the modulator 500 may operate in the ET mode based on controlling the APT switch 507 to turn off. In an embodiment, the state in which the APT switch 507 is turned off may be referred to as an "open state", and the term referring to the state of the APT switch is not limited thereto. The boost converter 501 may perform a boosting operation based on a current charged in the inductor 509 connected between the battery and the boost converter 501. When the modulator 500 operates in the ET mode, the voltage V_{boost} boosted by the boost converter 501 may be input to the linear regulator 503. The voltage boosted by the boost converter 501 may be maintained at the DC level by the capacitor 521 connected between the boost converter 501 and the ground. The linear regulator 503 may amplify the envelope signal V_{EV} input from the at least one RFIC 420. The linear regulator 503 may output the envelope voltage based on the voltage boosted by the boost converter 501 and the input envelope signal. In an embodiment, the buck converter 505 may supply a main current to a PA (e.g., the first PA 441). The modulator 500 may supply a voltage based on monitoring the envelope of the transmission signal to the PA based on outputting the envelope voltage.

In an embodiment, referring to FIG. 5B, the modulator 500 may operate in the APT mode based on controlling the APT switch 507 to turn on. In an embodiment, the state in which the APT switch 507 is turned on may be referred to as a "closed state", and the term referring to the state of the APT switch is not limited thereto. The linear regulator 503 may be turned off in the APT mode. The boost converter 501 may perform a boosting operation based on a current charged in the inductor 509 connected between the battery and the boost converter 501. When the modulator 500 operates in the APT mode, the voltage V_{AUX} boosted by the boost converter 501 may be input to the buck converter 505. The voltage boosted by the boost converter 501 may be maintained at the DC level by the capacitor 523 connected between the boost converter 501 and the ground. The buck converter 505 may output the DC voltage V_{buck} based on the output voltage of the battery and the voltage boosted by the boost converter 501. A current may be charged in the inductor 511 connected to the output end of the buck converter. The modulator 500 may supply a DC voltage of a level required for network communication to a PA (e.g., the first PA 441), based on outputting the DC voltage converted by the buck converter. The DC voltage converted by the buck converter may be maintained at the DC level by the capacitor 525 connected between the APT switch 507 and the ground.

In an embodiment, when network communication requiring high power is performed, the modulator 500 may supply a current corresponding to the envelope to the PA based on operating in the ET mode. In an embodiment, when network communication requiring low power is performed, the modulator 500 may supply a DC voltage of a specific level to the PA based on operating in the APT mode. In an embodiment, noise may be generated as the buck converter 505 of the modulator 500 performs a switching operation. Noise generated by the switching operation of the buck converter 505 may affect the output of the PA. For example, noise included in the output of the PA may generate a spur, which is an unwanted signal generated in a band other than the frequency band corresponding to network communication, or may deteriorate linearity of the PA. In an embodiment, the capacity of the capacitor 525 connected between the APT switch 507 and the ground may be set in units of uF to remove noise by the buck converter 505 and/or to implement a low-pass filter for DC output. In an embodiment, as the capacity of the capacitor 525 increases, the transition time for reaching the target voltage may increase. The capacity of the capacitor 525 may be set in units of uF to maintain the level of transition time required for network communication. For example, the capacity of the capacitor 525 may be set to about 4.7 uF to achieve about 10 us required for LTE network communication and/or 5G network communication, and the capacity of the capacitor 525 is not limited to the above-described example.

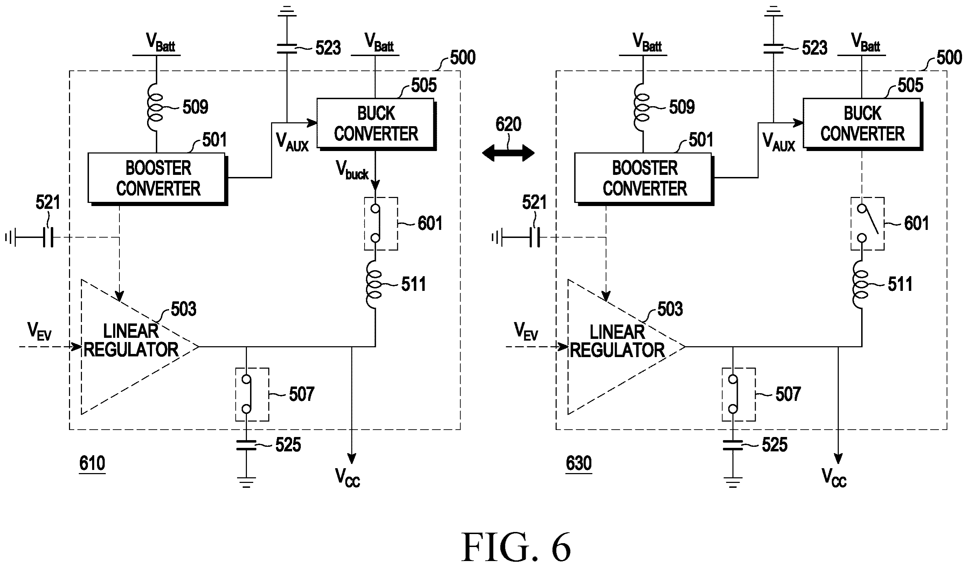

FIG. 6 is a view illustrating an operation of a modulator according to an embodiment.

In an embodiment, referring to FIG. 6, the modulator 500 may further include a switch 601 for increasing the capacitance of the modulator 500. The electronic device 101 may increase the capacitance of the modulator 500 based on controlling the switch 601 to turn off in the modulator 500 and controlling the APT switch 507 to turn on.

In an embodiment, referring to reference numeral 610, the modulator 500 may operate in a voltage output mode based on controlling the switch 601 and the APT switch 507 to turn on. In an embodiment, the modulator 500 may change 620 the state of the switch 601 based on switching. Referring to reference numeral 630, the modulator 500 may operate in a capacitance increase mode based on controlling the switch 601 to turn off and controlling the APT switch 507 to turn on. As compared with circuits lacking the switch 601, the electronic device 101 may reduce burnout of the modulator 500 due to the inflow of the current, supplied by another modulator, into the buck converter 505 and increase the capacitance of the modulator 500 based on controlling the switch 601 to turn off.

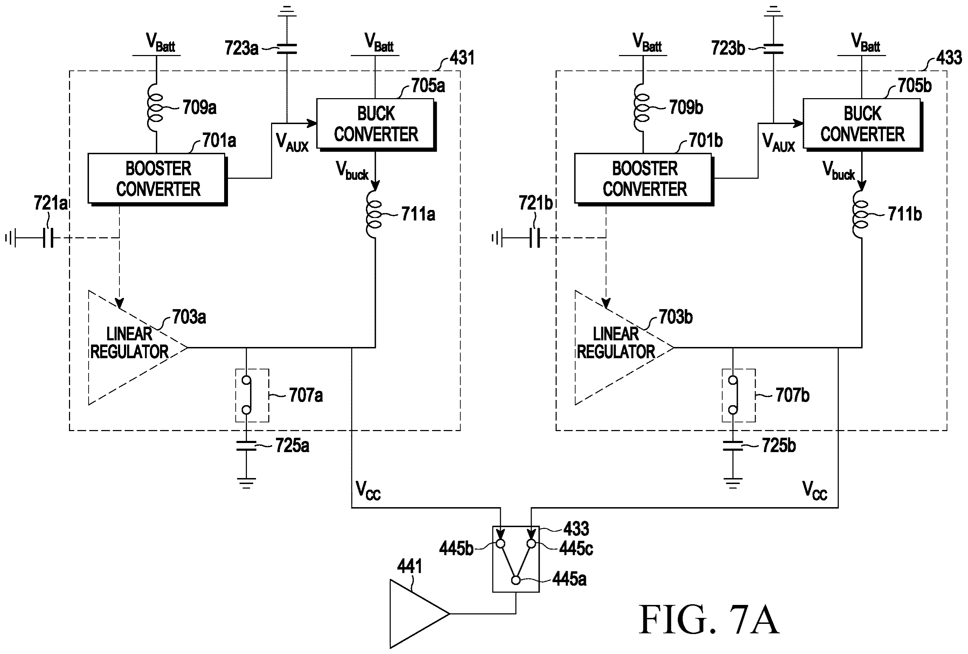

FIG. 7A is a view illustrating operations of modulators according to an embodiment.

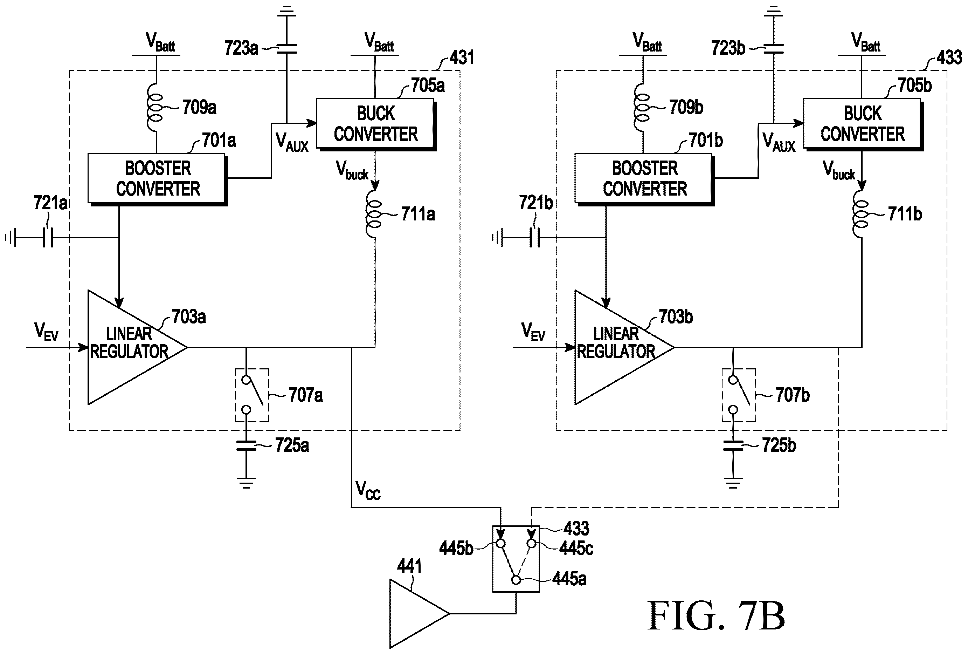

FIG. 7B is a view illustrating operations of modulators according to an embodiment.

In an embodiment, referring to FIG. 7A, the first modulator 431 and/or the second modulator 433 may supply a voltage to the first PA 441 based on operating in the ET mode or the APT mode. As described above with reference to FIG. 4, the SPnT switch 443 may electrically connect the first PA 441 to the first modulator 431 and/or the second modulator 433 based on switching. In an embodiment, the first modulator 431 and the second modulator 433 may include at least boost converters 701a and 701b, linear regulators 703a and 703b, buck converters 705a and 705b, and/or APT switches 725a and 725b, respectively. Functions of the boost converters 701a and 701b, the linear regulators 703a and 703b, the buck converters 705a and 705b, and the APT switches 725a and 725b may be substantially the same as those of the corresponding boost converter 501, the linear regulator 503, the buck converter 505, and the APT switch 507 of FIG. 5. The capacitors 721a, 721b, 723a, 723b, 725a, and 725b illustrated in FIG. 7A may bypass noise so that the voltage output by the converter is maintained at the DC level. The inductors 709a, 709b, 711a, and 711b illustrated in FIG. 7A may charge and/or discharge a current. In an embodiment, the first modulator 431 and the second modulator 433 may operate in the APT mode based on controlling the APT switches 707a and 707b to turn on. In an embodiment, the first modulator 431 and/or the second modulator 433 may be required to operate in the APT mode to perform network communication such as non-terrestrial network communication. The electronic device 101 may control the APT switches 707a and 707b to turn on, based on identifying the type of network communication. In an embodiment, based on identifying that the type of network communication is non-terrestrial network communication, the electronic device 101 may control the first modulator 431 and/or the second modulator 433 to operate in the APT mode regardless of whether the communication environment of the electronic device 101 is a weak electric field or a strong electric field. Based on operating the first modulator 431 and/or the second modulator 433 in the APT mode, the electronic device 101 may induce noise to the capacitors 725a and 725b without an additional component (e.g., a high-capacity capacitor). Based on operating the first modulator 431 and the second modulator 433 in the APT mode, the electronic device 101 may meet the transition time required by the network communication. In an embodiment, the magnitudes of the output voltages of the first modulator 431 and the second modulator 433 may be controlled substantially the same.

In an embodiment, referring to FIG. 7B, the first modulator 431 may operate in the ET mode based on controlling the APT switch 707a to turn off. For example, based on identifying that the type of network communication is LTE network communication and/or 5G network communication having a small bandwidth, the electronic device 101 may operate the first modulator 431 in the ET mode. The electronic device 101 may electrically connect the first PA 441 to the first modulator 431 based on controlling the SPnT switch 443. In case that the second modulator 433 supplies power to the first PA 441, the second modulator 433 may operate in the ET mode based on controlling the APT switch 707b to turn off. The electronic device 101 may efficiently adjust the amount of current supplied to the first PA 441 based on monitoring the envelope.

In an embodiment, based on identifying that the type of network communication is LTE network communication and/or 5G network communication having a small bandwidth, the electronic device 101 may change the operation mode of the modulator according to the communication environment of the electronic device 101. For example, the electronic device 101 may control the first modulator 431 to operate in the ET mode based on identifying that the electronic device 101 is positioned in a weak electric field. For example, the electronic device 101 may control the first modulator 431 and/or the second modulator 433 to operate in the APT mode, based on identifying that the electronic device 101 is positioned in a strong electric field.

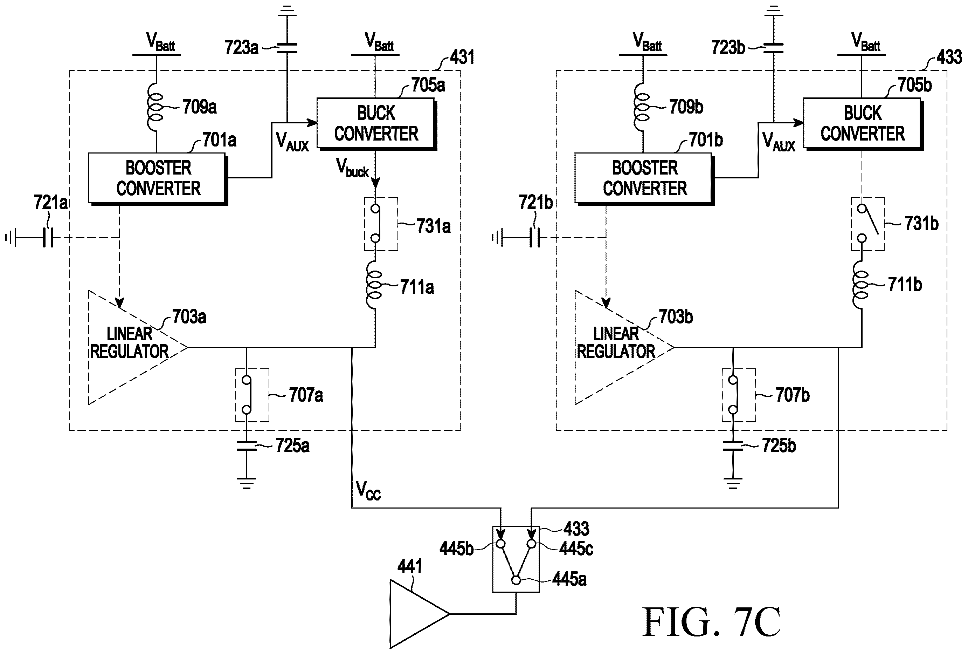

FIG. 7C is a view illustrating operations of modulators according to an embodiment.

In an embodiment, among the components illustrated in FIG. 7C, components having the same reference numerals as those of FIGS. 7A and 7B may perform substantially the same functions. In an embodiment, referring to FIG. 7C, the first modulator 431 of the electronic device 101 may further include a third switch 731a for increasing the capacitance of the first modulator 431. In an embodiment, the second modulator 433 of the electronic device 101 may further include a fifth switch 731b for increasing the capacitance of the second modulator 433. In an embodiment, the third switch 731a and the fifth switch 731b may be referred to as "capacitance switches" for convenience of description, but the functions and/or names of the third switch 731a and the fifth switch 731b are not limited to the above-described example. In an embodiment, one end of the third switch 731a may be connected to the buck converter 705a of the first modulator 431, and the other end may be connected to the inductor 711a of the first modulator 431. One end of the fifth switch 731b may be connected to the buck converter 705b of the second modulator 433, and the other end may be connected to the inductor 711b of the second modulator 433. In an embodiment, the electronic device 101 may control the first modulator 431 to operate in the voltage output mode, based on controlling the third switch 731a to turn on while the first modulator 431 operates in the APT mode. Based on controlling the fifth switch 731b to turn off while the second modulator 433 operates in the APT mode, the electronic device 101 may control the second modulator 433 to operate in the capacitance increase mode. Based on operating the second modulator 433 in the capacitance increase mode, the electronic device 101 may relatively reduce the burnout risk of the first modulator 431 and/or the second modulator 433 even without maintaining the output voltages of the first modulator 431 and the second modulator 433 at the same level.

In an embodiment, the electronic device 101 may supply power to the first PA 441 through the first modulator 431, based on detecting an event that causes the modulator to operate in the APT mode. Based on controlling the APT switch 707a and the third switch 731a of the first modulator 431 to turn on, the electronic device 101 may control the first modulator 431 to operate in the APT mode. The electronic device 101 may control the fifth switch 731b of the second modulator 433, which does not supply power to the first PA 441, to maintain the turned-off state while the first modulator 431 operates in the APT mode. The electronic device 101 may relatively reduce the risk of burnout of the second modulator 433 due to the inflow of the output current of the first modulator 431 into the buck converter 705b, based on turning off the fifth switch 731b connected to the output end of the buck converter 705b of the second modulator 433. The electronic device 101 may maintain the APT switch 707a of the first modulator 431 and the APT switch 707b of the second modulator 433 in the turned-on state while the first modulator 431 supplies power to the first PA 441. The electronic device 101 may provide relatively high capacitance based on maintaining the APT switches of the plurality of modulators in the turned-on state, and may control the first PA 441 to output a relatively high-power RF signal.

In an embodiment, based on identifying that the type of network communication is non-terrestrial network communication, the electronic device 101 may control the first modulator 431 to operate in the APT mode regardless of whether the communication environment of the electronic device 101 is a weak electric field or a strong electric field, and may provide relatively high capacitance based on maintaining the fifth switch 731b of the second modulator 433 in the turned-off state while the first modulator 431 operates in the APT mode.

In an embodiment, the electronic device 101 may include a first PA 441 selectively connected to at least one of a plurality of modulators through a first switch (e.g., the SPnT switch 443). The electronic device 101 may include a second switch (e.g., the APT switch 707a of the first modulator 431) connected between the first switch 443 and the first capacitor (e.g., the capacitor 725a of the first modulator 431) and a third switch (e.g., the capacitance switch 731a of the first modulator 431) connected to an output end of the first buck converter (e.g., the buck converter 705a of the first modulator 431), and may include the first modulator 431 among the plurality of modulators configured to selectively operate in the ET mode or the APT mode. The electronic device 101 may include a fourth switch (e.g., the APT switch 707b of the second modulator 433) connected between the first switch 443 and the second capacitor (e.g., the capacitor 725b of the second modulator 433) and a fifth switch (e.g., the capacitance switch 731b of the first modulator 431) connected to an output end of the second buck converter (the buck converter 705b of the second modulator 433), and may include a second modulator 433 among the plurality of modulators configured to selectively operate in the ET mode or the APT mode.

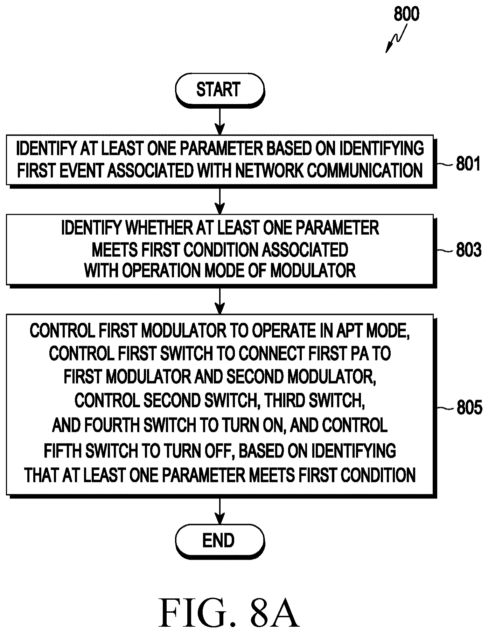

FIG. 8A is a flowchart 800 illustrating an operation method of an electronic device according to an embodiment.

According to an embodiment, in operation 801, the electronic device 101 (e.g., the processor 120, the first communication processor 212, the second communication processor 214, the integrated communication processor 260, and/or the communication processor 410) may identify at least one parameter associated with network communication, based on identifying a first event associated with the network communication. In an embodiment, as at least part of identifying the first event, the electronic device 101 may identify a user input that allows the electronic device 101 to perform network communication. In an embodiment, the user input may be a touch event to at least a portion of a display module (e.g., the display module 160), but the user input is not limited to the above-described example. In an embodiment, as at least part of identifying at least one parameter associated with network communication, the electronic device 101 may identify the type of network communication and/or the strength of the reception signal corresponding to the network communication.

In an embodiment, based on identifying at least one parameter associated with network communication, the electronic device 101 may identify whether at least one parameter meets a first condition associated with the operation mode of the modulator (e.g., the first modulator 431 and/or the second modulator 433) in operation 803. In an embodiment, as at least part of identifying whether the at least one parameter meets the first condition associated with the operation mode of the modulator, the electronic device 101 may identify whether the type of network communication identified in operation 801 meets a condition for allowing at least one modulator (e.g., the first modulator 431 and the second modulator 433) to operate in the APT mode. In an embodiment, the condition for allowing the at least one modulator to operate in the APT mode may be that the network communication corresponding to the first event is the first network communication. For example, the first network communication may include non-terrestrial network communication (e.g., satellite communication), global system for mobile communications (GSM)-based network communication, or high-band (HB) 5G network communication, but examples of the first network communication are not limited to the above-described examples. Based on identifying that the network communication corresponding to the first event is the first network communication, the electronic device 101 may identify that the condition for allowing the at least one modulator to operate in the APT mode is met. In an embodiment, the electronic device 101 may identify that the first condition is not met, based on identifying that the network communication corresponding to the first event is not the first network communication. For example, the electronic device 101 may identify that the first condition is not met, based on identifying that the network communication corresponding to the first event is the second network communication. For example, the second network communication may include LTE network communication or low-band (LB) 5G network communication, but examples of the second network communication are not limited to the above-described examples. Based on identifying that the first condition is not met, the electronic device 101 may set the operation mode of the modulator so that any one modulator (e.g., the first modulator 431 or the second modulator 433) among the at least one modulator operates in the ET mode. In an embodiment, it will be understood by one of ordinary skill in the art that the type of network communication may not necessarily correspond to the type of RAT. For example, when the network communication corresponding to the first event is the 5G network communication, the electronic device 101 may identify whether the network communication corresponding to the first event is the first communication network, based on the frequency band of the transmission signal corresponding to the 5G network communication. In an embodiment, as at least part of identifying whether the at least one parameter meets the first condition associated with the operation mode of the modulator, the electronic device 101 may identify whether the strength of the reception signal corresponding to the network communication identified in operation 801 meets the condition for allowing the at least one modulator (e.g., the first modulator 431 and the second modulator 433) to operate in the APT mode. In an embodiment, the condition for allowing the at least one modulator to operate in the APT mode may be that the strength of the reception signal corresponding to the network communication is a first value or more. For example, the first value may be a threshold value for stably performing network communication, and a specific value of the first value is not limited. Based on identifying that the strength of the reception signal corresponding to the network communication is the first value or more, the electronic device 101 may identify that the condition for allowing the at least one modulator to operate in the APT mode is met. In an embodiment, the electronic device 101 may identify that the first condition is not met, based on identifying that the strength of the reception signal corresponding to the network communication is less than the first value. Based on identifying that the first condition is not met, the electronic device 101 may set the operation mode of the modulator so that any one modulator (e.g., the first modulator 431 or the second modulator 433) among the at least one modulator operates in the ET mode. In an embodiment, it will be understood by one of ordinary skill in the art that the at least one parameter is not limited to the strength of the reception signal corresponding to network communication. For example, the strength of the reception signal may include a received signal strength indicator (RSSI), a reference signal received power (RSRP), or a reference signal received quality (RSRQ), and the at least one parameter is not limited to the above-described examples as long as the parameter is one for determining whether the environment of the reception channel corresponding to network communication is good. In an embodiment, the electronic device 101 may identify whether the at least one parameter meets the first condition associated with the operation mode of the modulator, based on a configured mapping table. For example, the configured mapping table may be a condition for defining the operation mode of the modulator according to the type of the network communication and/or the strength of the reception signal corresponding to the network communication.

In an embodiment, based on identifying that the at least one parameter meets the first condition, in operation 805, the electronic device 101 may control any one of the first modulator (e.g., the first modulator 431) or the second modulator (e.g., the second modulator 433) to operate in the APT mode, control the first switch (e.g., the SPnT switch 443 of FIG. 7C) to connect the first PA (e.g., the first PA 441 of FIG. 7C) to the first modulator 431 and the second modulator 433, control the second switch (e.g., the APT switch 707a of the first modulator 431 of FIG. 7C) and the third switch (e.g., the capacitance switch 731a of the first modulator 431 of FIG. 7C) of the modulator operating in the APT mode, and the fourth switch (e.g., the APT switch 707b of the second modulator 433 of FIG. 7C) of the remaining modulator to turn on, and control the fifth switch (e.g., the capacitance switch 731b of the second modulator 433 of FIG. 7C) of the remaining modulator to turn off while the modulator operating in the APT mode supplies power to the first PA 443. In an embodiment, the first PA may be a converged PA configured to amplify the RF signal corresponding to the first network communication and/or the second network communication.

In an embodiment, a first state in which the SPnT switch is turned on may be referred to as a "multi-on state", but is not limited thereto. In an embodiment, the output voltage of the modulator operating in the APT mode of the first modulator or the second modulator may be supplied to the first PA. In an embodiment, the output voltage of the modulator operating in the APT mode may be a target voltage for the first PA required for network communication. For example, the electronic device 101 may supply power to the first PA through the first modulator. The electronic device 101 may control the first modulator to operate in the APT mode based on controlling the APT switch (e.g., the APT switch 707a) and the first switch (e.g., the third switch 731a) of the first modulator to turn on. The electronic device 101 may control the second switch (e.g., the fifth switch 731b of FIG. 7C) of the second modulator that does not supply power to the first PA to maintain the turned-off state while the first modulator operates in the APT mode. The electronic device 101 may relatively reduce the risk of burnout of the second modulator due to the inflow of the output current of the first modulator into the buck converter of the second modulator, based on turning off the second switch connected to the output end of the buck converter (e.g., the buck converter 705b) of the second modulator. The electronic device 101 may maintain the APT switch of the first modulator and the APT switch (e.g., the APT switch 707b) of the second modulator in the turned-on state while the first modulator operates in the APT mode. The electronic device 101 may provide relatively high capacitance based on maintaining the APT switches of the plurality of modulators in the turned-on state.

In an embodiment, the electronic device 101 may control both the first modulator and the second modulator to supply power to the first PA. The electronic device 101 may control the SPnT switch in the multi-on state and may maintain the output voltages of the first modulator and the second modulator to be substantially the same while supplying power to the first PA. Based on maintaining the output voltages of the first modulator and the second modulator to be substantially the same, the electronic device 101 may relatively reduce the risk of damage of the modulator due to the inflow of the output current of one modulator into another modulator. In an embodiment, the electronic device 101 may control at least one RFIC (e.g., the at least one RFIC 420) to transmit a signal corresponding to network communication while the first modulator and the second modulator operate in the APT mode.

In an embodiment, based on identifying that the at least one parameter does not meet the first condition, the electronic device 101 may control one of the first modulator and or the second modulator to operate in the ET mode and may control the SPnT switch to electrically connect the first PA to one modulator configured to operate in the ET mode. Based on configuring the first modulator and/or the second modulator to operate in either the APT mode or the ET mode based on the identified at least one parameter, the electronic device 101 may support a plurality of network communications using a converged PA even without an additional component.

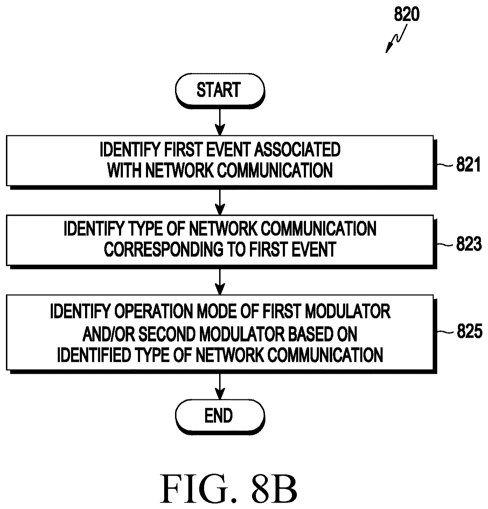

FIG. 8B is a flowchart 820 illustrating an operation method of an electronic device according to an embodiment.

According to an embodiment, the electronic device 101 (e.g., the processor 120, the first communication processor 212, the second communication processor 214, the integrated communication processor 260, and/or the communication processor 410) may identify a first event associated with network communication in operation 821. In an embodiment, since operation 821 is at least partially the same as operation 801, the description overlapping operation 801 may not be repeated here.

In an embodiment, the electronic device 101 may identify the type of network communication corresponding to the first event in operation 823, based on identifying the first event associated with the network communication. In an embodiment, the identified type of network communication may be first network communication or second network communication. For example, the first network communication may include non-terrestrial network communication, GSM-based network communication, or HB 5G network communication, but examples of the first network communication are not limited to the above-described examples. For example, the second network communication may include LTE network communication or LB 5G network communication, but examples of the second network communication are not limited to the above-described examples.

In an embodiment, the electronic device 101 may identify the operation mode of the first modulator (e.g., the first modulator 431) and/or the second modulator (e.g., the second modulator 433) in operation 825, based on the identified network communication type. For example, based on identifying that the network communication corresponding to the first event is the first network communication, the electronic device 101 may identify that the operation modes of the first modulator and the second modulator are the APT mode. For example, the electronic device 101 may identify that the operation mode of one of the first modulator or the second modulator is the ET mode, based on identifying that the network communication corresponding to the first event is the second network communication.

In an embodiment, the electronic device 101 may control at least one modulator (e.g., the first modulator 431 and the second modulator 433) and an SPnT switch (e.g., the SPnT switch 443), based on identifying the operation mode of the first modulator and/or the second modulator. For example, based on identifying that the operation modes of the first modulator and the second modulator are the APT mode, the electronic device 101 may control the first modulator and the second modulator to operate in the APT mode and may control the SPnT switch to connect the first PA to the first modulator and the second modulator. For example, the electronic device 101 may control the SPnT switch in the multi-on state. Based on identifying that the operation mode of one of the first modulator or the second modulator is the ET mode, the electronic device 101 may control the first modulator or the second modulator to operate in the ET mode and may control the SPnT switch to electrically connect the first PA (e.g., the first PA 441) to the modulator operating in the ET mode. For example, the electronic device 101 may control the SPnT switch in the single-on state.

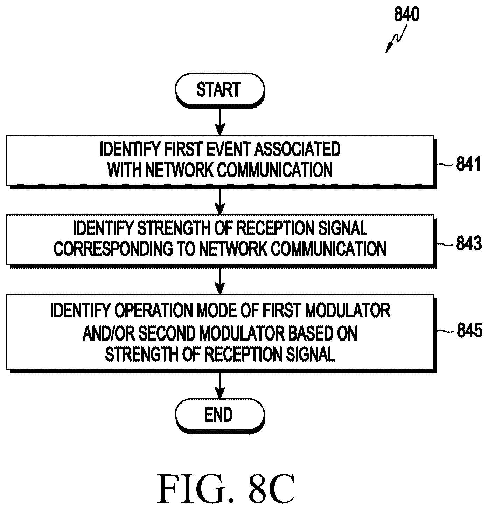

FIG. 8C is a flowchart 840 illustrating an operation method of an electronic device according to an embodiment.

According to an embodiment, the electronic device 101 (e.g., the processor 120, the first communication processor 212, the second communication processor 214, the integrated communication processor 260, and/or the communication processor 410) may identify a first event associated with network communication in operation 841. In an embodiment, since operation 841 is at least partially the same as operation 801, the description overlapping operation 801 may not be repeated.

In an embodiment, the electronic device 101 may identify the strength of the reception signal in operation 843, based on identifying the first event associated with the network communication. For example, the electronic device 101 may identify the RSSI, RSRP, or RSRQ of the reception signal corresponding to the network communication, and the parameters associated with the reception signal are not limited to the above-described example.

In an embodiment, the electronic device 101 may identify the operation state or mode of the first modulator (e.g., the first modulator 431) and/or the second modulator (e.g., the second modulator 433) in operation 845, based on the identified strength of the reception signal. In an embodiment, based on identifying that the strength of the reception signal corresponding to the network communication is the first value or more, the electronic device 101 may identify that the operation modes of the first modulator and the second modulator are the APT mode. Based on identifying that the strength of the reception signal corresponding to the network communication is less than the first value, the electronic device 101 may identify that any one modulator (e.g., the first modulator 431 or the second modulator 433) of the at least one modulator is in the ET mode.

In an embodiment, based on identifying that the strength of the reception signal is the first value or more, the electronic device 101 may control the first modulator and the second modulator to operate in the APT mode, and may control the SPnT switch in the multi-on state. Based on identifying that the strength of the reception signal is less than the first value, the electronic device 101 may control the first modulator to operate in the ET mode and may control the SPnT switch in the single-on state to electrically connect the first PA to the first modulator.

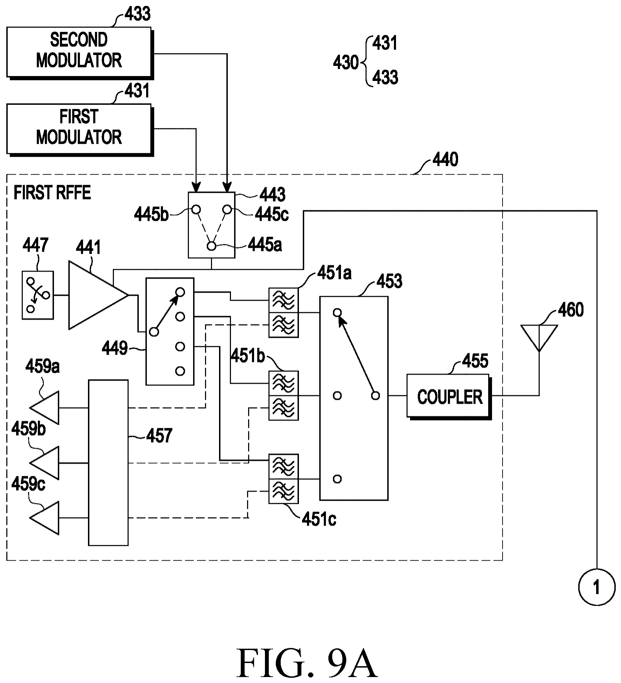

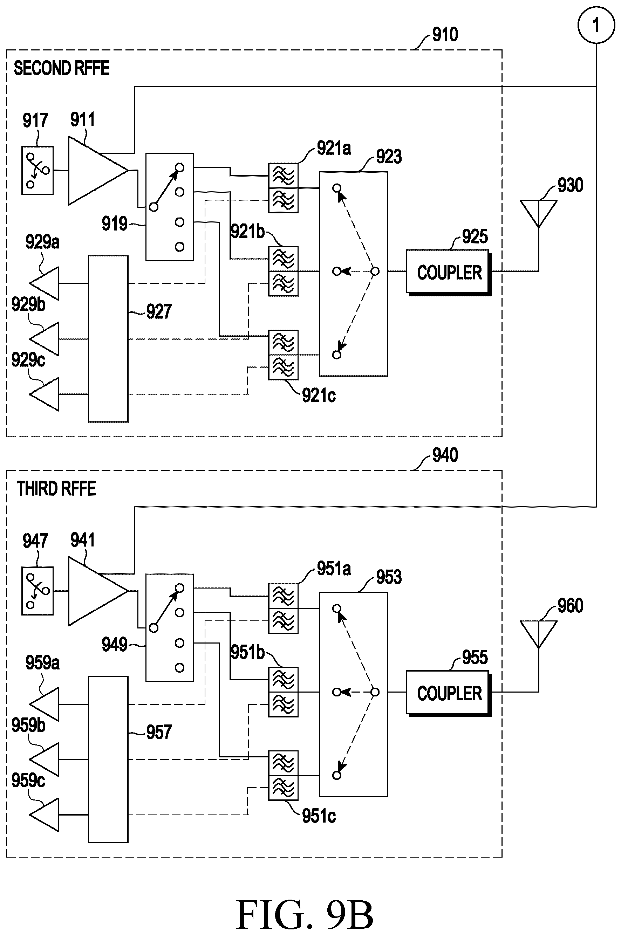

FIGS. 9A and 9B are block diagrams illustrating an electronic device for supporting non-terrestrial network communication according to an embodiment.

In an embodiment, referring to FIGS. 9A and 9B, the electronic device 101 may further include at least one PA 911 and 941 electrically connected to at least one of the first modulator 431 or the second modulator 433. In an embodiment, based on the line connected to the input port 445a of the SPnT switch 443, the second PA 911 of the second RFFE 910 and/or the third PA 941 of the third RFFE 940 may receive current from the first modulator 431 and/or the second modulator 433. The electronic device 101 may at least transmit a signal corresponding to a plurality of network communications through any one PA among the plurality of PAs (e.g., the first PA 441, the second PA 911, and the third PA 941) based on multi-RAT, based on the circuits illustrated in FIGS. 9A and 9B. For example, the electronic device 101 may at least transmit a signal corresponding to a plurality of network communications, based on the second antenna module 930 or the third antenna module 960.

In an embodiment, the functions of the SPDT switches 917 and 947 and the transmission switches 919 and 949 of the second RFFE 910 and the third RFFE 940, the at least one duplexer 921a, 951a, 921b, 951b, 921c, and 951c, the antenna switch modules 923 and 953, the couplers 925 and 955, the reception switches 927 and 957, and/or the at least one LNA 929a, 959a, 929b, 959b, 929c, and 959c may be substantially the same as those of the SPDT switch 447 of the first RFFE 440, the transmission switch 449, the at least one duplexer 451a, 451b, and 451c, the antenna switch module 453, the coupler 455, the reception switch 457, and/or the at least one LNA 459a, 459b, and 459c.

According to an example embodiment, an electronic device 101 may include: memory storing instructions, and a first power amplifier (PA) 441 selectively connected to at least one of a plurality of modulators through a first switch 443. The electronic device 101 may include a first modulator 431 including a second switch 707a connected between the first switch 443 and a first capacitor 725a and a third switch 731a connected to an output end of a first buck converter 705a, the first modulator being among the plurality of modulators configured to selectively operate in an envelope tracking (ET) mode or an average power tracking (APT) mode. The electronic device 101 may include a second modulator 433 including a fourth switch 707b connected between the first switch 443 and a second capacitor 725b and a fifth switch 731b connected to an output end of a second buck converter 705b, the second modulator being among the plurality of modulators configured to selectively operate in the ET mode or the APT mode. The electronic device 101 may include at least one processor120, 212, 214, 260, or 410 , comprising processing circuitry, operatively connected to the first PA 441, the first modulator 431, and the second modulator 433. The instructions, when executed by at least one processor 120, 212, 214, 260, or 410, may cause the electronic device 101 to control the first modulator 431 to operate in the APT mode based on identifying a first event associated with network communication, control the first switch 443 to connect the first PA 441 to the first modulator 431 and the second modulator 433. The instructions, when executed by at least one processor 120, 212, 214, 260, or 410, may cause the electronic device 101 to control the second switch 707a, the third switch 713a, and the fourth switch 707b to turn on. The instructions, when executed by at least one processor 120, 212, 214, 260, or 410, may cause the electronic device 101 to control the fifth switch 731b to turn off while the first modulator 431 operates in the APT mode.

In an example embodiment, the instructions, when executed by at least one processor 120, 212, 214, 260, or 410, may cause the electronic device 101 to identify at least one parameter based on identifying the first event associated with the network communication. The instructions, when executed by at least one processor 120, 212, 214, 260, or 410, may cause the electronic device 101 to identify whether the at least one parameter meets a first condition associated with an operation mode of a modulator. The instructions, when executed by at least one processor 120, 212, 214, 260, or 410, may cause the electronic device 101 to control the first modulator 431 and the second modulator 433 to operate in the APT mode based on identifying that the at least one parameter meets the first condition. The instructions, when executed by at least one processor 120, 212, 214, 260, or 410, may cause the electronic device 101 to transmit a signal corresponding to the network communication while the first modulator 431 and the second modulator 433 operate in the APT mode.

In an example embodiment, the instructions, when executed by at least one processor 120, 212, 214, 260, or 410 of the electronic device 101, may cause the electronic device 101 to identify a type of network communication corresponding to the first event as at least part of identifying the at least one parameter based on identifying the first event associated with the network communication. The instructions, when executed by at least one processor 120, 212, 214, 260, or 410 of the electronic device 101, may cause the electronic device 101 to identify an operation state of the first modulator 431 and/or the second modulator 433 based on the identified type of the network communication.

In an example embodiment, the instructions, when executed by at least one processor 120, 212, 214, 260, or 410 of the electronic device 101, may cause the electronic device 101 to, as at least part of controlling the first modulator 431 and the second modulator 433 to operate in the APT mode, control the first modulator 431 and the second modulator 433 to operate in the APT mode and control the first switch 443 to connect the first PA 441 to the first modulator 431 and the second modulator 433, based on identifying that the type of the network communication corresponding to the first event is a first network communication.

In an example embodiment, the instructions, when executed by at least one processor 120, 212, 214, 260, or 410 of the electronic device 101, may cause the electronic device 101 to control the first modulator 431 to operate in the ET mode and control the first switch 443 to electrically connect the first PA 441 to the first modulator 431, based on identifying that the type of the network communication corresponding to the first event is a second network communication.

In an example embodiment, the instructions, when executed by at least one processor 120, 212, 214, 260, or 410 of the electronic device 101, may cause the electronic device 101 to identify a strength of a reception signal corresponding to the network communication as at least part of identifying the at least one parameter based on identifying the first event associated with the network communication. The instructions, when executed by at least one processor 120, 212, 214, 260, or 410 of the electronic device 101, may cause the electronic device 101 to identify an operation state of the first modulator 431 and/or the second modulator 433 based on the strength of the reception signal.

In an example embodiment, the instructions, when executed by at least one processor 120, 212, 214, 260, or 410 of the electronic device 101, may cause the electronic device 101 to, as at least part of controlling the first modulator 431 and the second modulator 433 to operate in the APT mode, control the first modulator 431 and the second modulator 433 to operate in the APT mode and control the first switch 443 to connect the first PA 441 to the first modulator 431 and the second modulator 433, based on identifying that the strength of the reception signal is a first value or more.

In an example embodiment, the instructions, when executed by at least one processor 120, 212, 214, 260, or 410 of the electronic device 101, may cause the electronic device 101 to control the first modulator 431 to operate in the ET mode and control the first switch 443 to electrically connect the first PA 441 to the first modulator 431, based on identifying that the strength of the reception signal is less than the first value.

In an example embodiment, an output voltage of the first modulator 431 of the electronic device 101 and may correspond to the output voltage of the second modulator 433 of the electronic device 101 while power is supplied to the first PA 441.

In an example embodiment, the instructions, when executed by at least one processor 120, 212, 214, 260, or 410 of the electronic device 101, may cause the electronic device 101 to maintain the first switch 443 in a multi-on state while the first modulator 431 operates in the APT mode, and the fifth switch 731b is turned off.

In an example embodiment, the electronic device 101 may further include at least one PA 911 and 941 electrically connected to at least one of the first modulator 431 or the second modulator 433.

According to an example embodiment, a method for operating an electronic device 101 may include controlling a first modulator 431 of the electronic device 101 configured to selectively operate in an envelope tracking (ET) mode or an average power tracking (APT) mode to operate in the APT mode based on identifying a first event associated with network communication, controlling a first switch 443 of the electronic device 101 to connect a first power amplifier (PA) 441 of the electronic device 101 to the first modulator 431 and the second modulator 433. The method may include controlling a second switch 707a and a third switch 731a of the first modulator 431 and a fourth switch 707b of a second modulator 433 of the electronic device 101 to turn on. The method may include controlling a fifth switch 731b of the second modulator 433 to turn off while the first modulator 431 operates in the APT mode.

In an example embodiment, the method for operating the electronic device 101 may further include identifying at least one parameter based on identifying the first event associated with the network communication. The method for operating the electronic device 101 may include identifying whether the at least one parameter meets a first condition associated with an operation mode of a modulator. The method for operating the electronic device 101 may include controlling the first modulator 431 of the electronic device 101 configured selectively operate in the ET mode or the APT mode and the second modulator 433 of the electronic device 101 configured selectively operate in the ET mode or the APT mode to operate in the APT mode based on identifying that the at least one parameter meets the first condition. The method for operating the electronic device 101 may further include transmitting a signal corresponding to the network communication while the first modulator 431 and the second modulator 433 operate in the APT mode.

In an example embodiment, the identifying the at least one parameter based on identifying the first event associated with the network communication may include identifying a type of network communication corresponding to the first event. The method for operating the electronic device 101 may further include identifying an operation state of the first modulator 431 and/or the second modulator 433 based on the identified type of the network communication.

In an example embodiment, the controlling the first modulator 431 and the second modulator 433 to operate in the APT mode may include controlling the first modulator 431 and the second modulator 433 to operate in the APT mode and control the first switch 443 to connect the first PA 441 to the first modulator 431 and the second modulator 433, based on identifying that the type of the network communication corresponding to the first event is a first network communication.

In an example embodiment, the method for operating the electronic device 101 may further include controlling the first modulator 431 to operate in the ET mode and control the first switch 443 to electrically connect the first PA 441 to the first modulator 431, based on identifying that the type of the network communication corresponding to the first event is a second network communication.

In an example embodiment, the identifying the at least one parameter based on identifying the first event associated with the network communication may include identifying a strength of a reception signal corresponding to the network communication. The method for operating the electronic device 101 may further include identifying an operation state of the first modulator 431 and/or the second modulator 433 based on the strength of the reception signal.

In an example embodiment, the controlling the first modulator 431 and the second modulator 433 to operate in the APT mode may include controlling the first modulator 431 and the second modulator 433 to operate in the APT mode and controlling the first switch 443 to connect the first PA 441 to the first modulator 431 and the second modulator 433, based on identifying that the strength of the reception signal is a first value or more.

In an example embodiment, the method for operating the electronic device 101 may further include controlling the first modulator 431 to operate in the ET mode and controlling the first switch 443 to electrically connect the first PA 441 to the first modulator 431, based on identifying that the strength of the reception signal is less than the first value.

In an example embodiment, the method for operating the electronic device 101 may further include maintaining the first switch 443 in a multi-on state while the first modulator 431 operates in the APT mode, and the fifth switch 731b is turned off.

The electronic device according to an embodiment may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

An embodiment of the disclosure may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities. Some of the plurality of entities may be separately disposed in different components. According to an embodiment, one or more of the above-described components may be omitted, or one or more other components may be added. Alternatively or Further, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a first power amplifier (PA) (441) selectively connected to at least one of a plurality of modulators through a first switch (443);
a first modulator (431) among the plurality of modulators configured to selectively operate in an envelope tracking (ET) mode or an average power tracking (APT) mode, wherein the first modulator (431) includes a second switch (707a) connected between the first switch (443) and a first capacitor (725a) and a third switch (731a) connected to an output end of a first buck converter (705a);
a second modulator (433) among the plurality of modulators configured to support the ET mode or the APT mode, wherein the second modulator (433) includes a fourth switch (707b) connected between the first switch (443) and a second capacitor (725b) and a fifth switch (731b) connected to an output end of a second buck converter (705b);
at least one processor, comprising processing circuitry, (120, 212, 214, 260, 410) operatively connected to the first PA (441), the first modulator (431), and the second modulator (433); and
memory (130) storing instructions,
wherein the instructions, when executed by at least one processor (120,212,214,260,410), cause the electronic device (101) to:
based on identifying a first event associated with network communication, control the first modulator (431) to operate in the APT mode control the first switch (443) to connect the first PA (441) to the first modulator (431) and the second modulator (433), control the second switch (707a), the third switch (731a), and the fourth switch (707b) to turn on, and control the fifth switch (731b) to turn off based on the first modulator (431) operating in the APT mode.

2. The electronic device (101) of claim 1, wherein the instructions, when executed by at least one processor (120,212,214,260,410), cause the electronic device (101) to:
identify at least one parameter based on identifying the first event associated with the network communication;
identify whether the at least one parameter meets a first condition associated with an operation mode of a modulator;
control the first modulator (431) and the second modulator (433) to operate in the APT mode based on identifying that the at least one parameter meets the first condition; and
transmit a signal corresponding to the network communication based on the first modulator (431) and the second modulator (433) operating in the APT mode.

3. The electronic device (101) of claim 1 or 2,
wherein the instructions, when executed by at least one processor (120,212,214,260,410), cause the electronic device (101) to:
identify a type of network communication corresponding to the first event as at least part of identifying the at least one parameter based on identifying the first event associated with the network communication, and
identify an operation state of the first modulator (431) and/or the second modulator (433) based on the identified type of the network communication.

4. The electronic device (101) of any one of claims 1 to 3,
wherein the instructions, when executed by at least one processor (120,212,214,260,410), cause the electronic device (101) to:
as at least part of controlling the first modulator (431) and the second modulator (433) to operate in the APT mode,
based on identifying that the type of the network communication corresponding to the first event is a first network communication, control the first modulator (431) and the second modulator (433) to operate in the APT mode and control the first switch (443) to connect the first PA (441) to the first modulator (431) and the second modulator (433).

5. The electronic device (101) of any one of claims 1 to 4,
wherein the instructions, when executed by at least one processor (120,212,214,260,410), cause the electronic device (101) to:
based on identifying that the type of the network communication corresponding to the first event is a second network communication, control the first modulator (431) to operate in the ET mode and control the first switch (443) to electrically connect the first PA (441) to the first modulator (431).

6. The electronic device (101) of any one of claims 1 to 5,
wherein the instructions, when executed by at least one processor (120,212,214,260,410) cause the electronic device (101) to:
identify a strength of a reception signal corresponding to the network communication as at least part of identifying the at least one parameter based on identifying the first event associated with the network communication, and
identify an operation state of the first modulator (431) and/or the second modulator (433) based on the strength of the reception signal.

7. The electronic device (101) of any one of claims 1 to 6,
wherein the instructions, when executed by at least one processor (120,212,214,260,410), cause the electronic device (101) to:
as at least part of controlling the first modulator (431) and the second modulator (433) to operate in the APT mode,
based on identifying that the strength of the reception signal is a first value or more, control the first modulator (431) and the second modulator (433) to operate in the APT mode and control the first switch (443) to connect the first PA (441) to the first modulator (431) and the second modulator (433).

8. The electronic device (101) of any one of claims 1 to 7,
wherein the instructions, when executed by at least one processor (120,212,214,260,410), cause the electronic device (101) to:
based on identifying that the strength of the reception signal is less than the first value, control the first modulator (431) to operate in the ET mode and control the first switch (443) to electrically connect the first PA (441) to the first modulator (431).

9. The electronic device (101) of any one of claims 1 to 8,
wherein an output voltage of the first modulator (431) corresponds to an output voltage of the second modulator (433) based on power being supplied to the first PA (441).

10. The electronic device (101) of any one of claims 1 to 9,
wherein the instructions, when executed by at least one processor (120,212,214,260,410) cause the electronic device (101) to:
maintain the first switch (443) in a multi-on state based on the first modulator (431) operating in the APT mode, and the fifth switch (731b) being turned off.

11. The electronic device (101) of any one of claims 1 to 10, further comprising
at least one PA (911, 941) electrically connected to at least one of the first modulator (431) or the second modulator (433).

12. A method for operating an electronic device (101), the method comprising,
based on identifying a first event associated with network communication, controlling a first modulator (431) of the electronic device (101) configured to selectively operate in an envelope tracking (ET) mode or an average power tracking (APT) mode to operate in the APT mode, and controlling a first switch (443) of the electronic device (101) to connect a first power amplifier (PA) (441) of the electronic device (101) to the first modulator (431) and a second modulator (433);
controlling a second switch (707a) and a third switch (731a) of the first modulator (431) and a fourth switch (707b) of a second modulator (433) of the electronic device (101) to turn on; and
controlling a fifth switch (731b) of the second modulator (433) to turn off based on the first modulator (431) operating in the APT mode.

13. The method of claim 12, further comprising:
identifying at least one parameter based on identifying the first event associated with the network communication;
identifying whether the at least one parameter meets a first condition associated with an operation mode of a modulator;
controlling the first modulator (431) of the electronic device (101) configured to selectively operate in the ET mode or the APT mode and the second modulator (433) of the electronic device (101) configured to selectively operate in the ET mode or the APT mode to operate in the APT mode based on identifying that the at least one parameter meets the first condition; and
transmitting a signal corresponding to the network communication based on the first modulator (431) and the second modulator (433) operating in the APT mode.

14. The method of claim 12 or 13,
wherein the identifying the at least one parameter based on identifying the first event associated with the network communication includes identifying a type of network communication corresponding to the first event, and
wherein the method further includes identifying an operation state of the first modulator (431) and/or the second modulator (433) based on the identified type of the network communication.

15. A computer-readable storage medium storing instructions that, when executed by at least one processor, individually and/or collectively, of an electronic device, cause the electronic device to perform at least one operation comprising:
based on identifying a first event associated with network communication, controlling a first modulator (431) of the electronic device (101) configured to selectively operate in an envelope tracking (ET) mode or an average power tracking (APT) mode to operate in the APT mode, and controlling a first switch (443) of the electronic device (101) to connect a first power amplifier (PA) (441) of the electronic device (101) to the first modulator (431) and a second modulator (433);
controlling a second switch (707a) and a third switch (731a) of the first modulator (431) and a fourth switch (707b) of a second modulator (433) of the electronic device (101) to turn on; and
controlling a fifth switch (731b) of the second modulator (433) to turn off based on the first modulator (431) operating in the APT mode.
